# EUROPÄISCHE PATENTSCHRIFT

(11) **EP 0 517 135 B1**
(45) Veröffentlichungstag und Bekanntmachung des Hinweises auf die Patenterteilung: **10.05.1995**
(21) Anmeldenummer: 92109185.6
(22) Anmeldetag: 01.06.1992
(51) Int. Cl.: H05K 9/00

(54) **Kontaktfederstreifen**
Contact spring strip
Bande à ressort de contact

(30) Priorität: 06.06.1991 DE 9106956 U
(43) Veröffentlichungstag der Anmeldung: 09.12.1992
(73) Patentinhaber: SIEMENS AKTIENGESELLSCHAFT, 80333 München (DE)
(72) Erfinder: Störk, Peter, W-8196 Eurasburg (DE)

(56) Entgegenhaltungen:
- DE-A- 3 328 386
- DE-A- 3 527 267
- DE-A- 3 642 588
- DE-B- 2 247 005
- DE-U- 8 626 126

## Beschreibung

Die Erfindung betrifft einen Kontaktfederstreifen zum elektromagnetischen Abdichten von Gehäuseteilen eines Schirmgehäuses, wobei der Kontaktfederstreifen mit jeweils zwei der Gehäuseteile kontaktierbar ist.

Derartige Kontaktfederstreifen sind z. B. aus dem deutschen Gebrauchsmuster G 86 26 126 bekannt. Diese Kontaktfederstreifen sind durchgehend streifenförmig und in Längsrichtung gewölbt ausgebildet und besitzen an ihren Längskanten krallenartige Fortsätze.

Ein Nachteil dieser bekannten Kontaktfederstreifen besteht darin, daß sie in unterschiedlichen festen Längen hergestellt werden, was zu einem erheblichen Produktionsaufwand und zu einer großen Lagerhaltung zwingt. Ein weiterer Nachteil ist dadurch gegeben, daß eine in Längsrichtung verlaufende leichte Wölbung produktionstechnisch schwierig herzustellen ist.

Es ist nun die Aufgabe der vorliegenden Erfindung, Kontaktfederstreifen der eingangs genannten Art so auszubilden, daß diese einfach und kostengünstig herstellbar sind und in beliebigen Längen verwendbar sind.

Dies wird dadurch erreicht, daß der Kontaktfederstreifen aus einer vielzahl von einzelnen, durch Trennstege miteinander verbundenen Kontaktfedern besteht, wobei die einzelne Kontaktfeder aus einem abgewinkelten und von zwei in die gleiche Richtung abgewinkelten Schenkeln begrenzten Mittelbereich besteht, wobei an der Außenkante des ersten Schenkels mindestens ein einwärts gebogener Federhaken vorgesehen ist, und daß der äußere Randbereich des zweiten Schenkels über seine gesamte Länge einwärts gebogen ist, wobei an der Außenkante des äußeren abgebogenen Randbereichs zumindest ein halbkreisförmiger Ansatz angeordnet ist.

Durch die Vermeidung einer in Längsrichtung des Kontaktfederstreifens verlaufenden Wölbung ist erfindungsgemäß der Kontaktfederstreifen leicht herzustellen. Dadurch, daß der Kontaktfederstreifen in eine Vielzahl von einzelnen Kontaktfedern, die mittels Trennstege miteinander verbunden sind, unterteilt ist, kann der Kontaktfederstreifen gemäß der vorliegenden Erfindung in beliebiger Länge als sogenannte "Meterware" hergestellt werden. Erst kurz vor der Montage kann der Kontaktfederstreifen auf einfache Art und Weise, nämlich durch einfaches Abbrechen bzw. Durchschneiden, auf die gewünschte Länge gebracht werden.

Aufgrund der Federhaken auf der einen und der halbkreisförmigen Ansätze auf der anderen Seite eignet sich der Kontaktfederstreifen gemäß der vorliegenden Erfindung insbesondere für Gehäusetüren mit abgewinkelten Türkanten.

Eine zweckmäßige Weiterbildung des erfindungsgemäßen Kontaktfederstreifens ist dadurch gekennzeichnet, daß im Außenbereich der beiden Schenkel einwärtsweisende Pocken angeordnet sind. Auf diese Weise wird ein hoher definierter Kontaktdruck zwischen Kontaktfederstreifen und Gehäusetür erzielt.

Nachfolgend wird die Erfindung anhand eines in der Zeichnung dargestellten Ausführungsbeispiels näher erläutert.

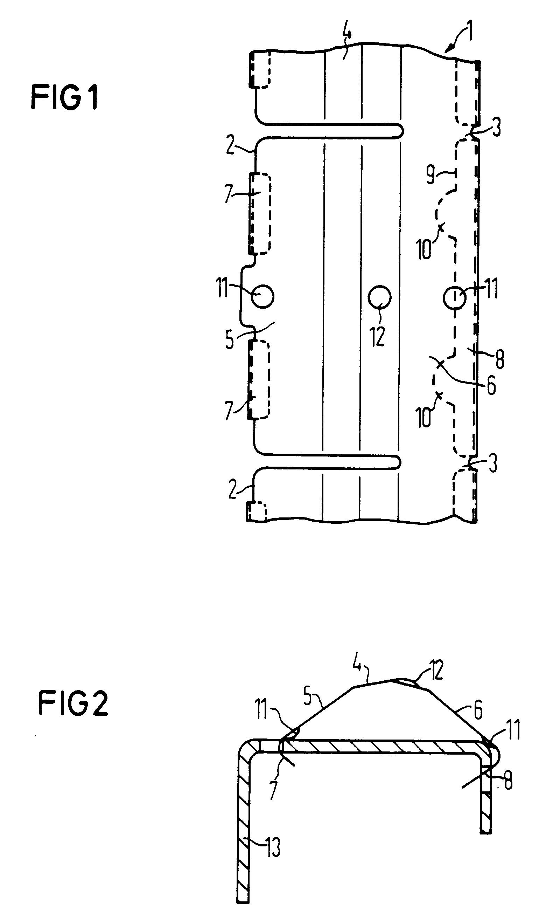

Es zeigt
- FIG 1: eine Aufsicht auf einen Teil eines gemäß der Erfindung gestalteten Kontaktfederstreifens, und
- FIG 2: einen Querschnitt durch eine Kontaktfeder des in FIG 1 gezeigten Kontaktfederstreifens und durch den Randbereich einer Gehäusetür, an welcher der Kontaktfederstreifen befestigt ist.

Der in der Zeichnung dargestellte Kontaktfederstreifen 1 besteht aus einer Vielzahl von über Trennstege 3 miteinander verbundenen Kontaktfedern 2. Dadurch kann der Kontaktfederstreifen "endlos" gefertigt und anschließend aufgerollt werden. Erst bei der Montage wird der Kontaktfederstreifen durch einfaches Abschneiden von der Rolle auf die gewünschte Länge gebracht. Hierdurch entfällt die Lagerhaltung unterschiedlicher Längentypen.

Nachfolgend soll die einzelne Kontaktfeder näher beschrieben werden. Die im Ausführungsbeispiel dargestellte Kontaktfeder 2 besteht aus einem in der Mitte abgewinkelten Mittelbereich 4, der von einem ersten Schenkel 5 und einem zweiten Schenkel 6 begrenzt wird. An der Außenkante des ersten Schenkels 5 sind einwärts gebogene Federhaken 7 vorgesehen. Der äußere Randbereich 8 des zweiten Schenkels 6 ist über seine gesamte Länge einwärts abgebogen. Dabei sind an der Außenkante 9 dieses äußeren abgebogenen Randbereichs 8 halbkreisförmige Ansätze 10 angeordnet. Die Federhaken 7 und die halbkreisförmigen Ansätze 10 sind so ausgebildet, daß sie die einzelnen Kontaktfedern 2 unter Vorspannung zwischen gegenüberliegenden Öffnungen halten, welche sich im U-förmigen Randbereich einer Gehäusetür 13 befinden.

Im geschlossenen Zustand der Gehäusetür 13 dienen die einwärtsweisenden Pocken 11 im Außenbereich der beiden Schenkel 5 und 6 zur Erzielung eines definierten, hohen Kontaktdruckes zwischen Kontaktfeder 2 und Gehäusetür 13. Ebenfalls zur Erzielung eines definierten und hohen Kontaktdrucks zwischen der Kontaktfeder und einem die Gehäusetür umgebenden Gehäuseteil dient die im Mittelbereich 4 angebrachte Warze 12.

## Patentansprüche

1. Kontaktfederstreifen zum elektromagnetischen Abdichten von Gehäuseteilen eines Schirmgehäuses, wobei der Kontaktfederstreifen mit jeweils zwei der Gehäuseteile kontaktierbar ist,
**dadurch gekennzeichnet**,
daß der Kontaktfederstreifen (1) aus einer Vielzahl von einzelnen, durch Trennstege (3) miteinander verbundenen Kontaktfedern (2) besteht, wobei die einzelne Kontaktfeder (2) aus einem abgewinkelten und von zwei in die gleiche Richtung abgewinkelten Schenkeln (5, 6) begrenzten Mittelbereich (4) besteht, wobei an der Außenkante des ersten Schenkels (5) mindestens ein einwärts gebogener Federhaken (7) vorgesehen ist, und daß der äußere Randbereich (8) des zweiten Schenkels (6) über seine gesamte Länge einwärts abgebogen ist, wobei an der Außenkante (9) des äußeren abgebogenen Randbereichs (8) zumindest ein halbkreisförmiger Ansatz (10) angeordnet ist.

2. Kontaktfederstreifen nach Anspruch 1,
**dadurch gekennzeichnet**,
daß im Außenbereich der beiden Schenkel (5, 6) einwärtsweisende Pocken (11) angeordnet sind.

## Claims

1. Contact spring strip for electromagnetically sealing housing parts of a screening housing, it being possible to contact the contact spring strip to respectively two of the housing parts, characterized in that the contact spring strip (1) comprises a multiplicity of individual contact springs (2) connected to one another by separating webs (3), the individual contact springs (2) comprising a bent middle region (4) bounded by two legs (5, 6) bent in the same direction, at least one inwardly bent spring hook (7) being provided on the outer edge of the first leg (5), and in that the outer edge region (8) of the second leg (6) is bent inwardly over its entire length, at least one semicircular projection (10) being arranged on the outer edge (9) of the outer bent edge region (8).

2. Contact spring strip according to Claim 1, characterized in that inwardly pointing pocks (11) are arranged in the outer region of the two legs (5, 6).

## Revendications

1. Bande élastique de contact pour la protection électromagnétique de parties d'un boîtier de blindage, la bande élastique de contact pouvant être en contact avec deux des parties du boîtier,
caractérisée en ce que la bande élastique de contact (1) est constituée d'une multiplicité de ressorts individuels de contact (2), qui sont reliés entre eux par des barrettes de séparation (3), chacun des ressorts individuels de contact (2) étant constitué d'une partie centrale (4) repliée, et délimitée par deux branches (5,6) repliées dans le même sens, au moins un crochet élastique (7) coudé vers l'intérieur étant prévu sur le bord extérieur de la première branche (5), et en ce que la partie marginale extérieure (8) de la seconde branche (6) est coudée vers l'intérieur sur toute sa longueur, au moins une saillie de forme hemi-circulaire (10) étant prévue sur le bord extérieur (9) de la partie marginale extérieure (8) coudée.

2. Bande élastique de contact suivant la revendication 1, caractérisée en ce que des moulures rentrantes (12) sont prévues dans la partie extérieure des deux branches (5,6).
